# EUROPEAN PATENT APPLICATION

(11) **EP 4 663 973 A1**
(43) Date of publication of application: **17.12.2025**
(21) Application number: 24753315.1
(22) Date of filing: 05.02.2024
(51) Int. Cl.: F16F 9/32, B60G 13/08, C23C 16/32, F16F 9/19, C10N 40/06

(54) **SHOCK ABSORBER**

(30) Priority: 10.02.2023 JP 2023019086
(71) Applicant: Astemo, Ltd., Chiyoda-ku, Tokyo 1000004 (JP)
(72) Inventor: INABA Hiroshi, Hitachinaka-shi, Ibaraki 312-8503 (JP); HOSHINO Akihito, Hitachinaka-shi, Ibaraki 312-8503 (JP); OMATA Yasuhisa, Hitachinaka-shi, Ibaraki 312-8503 (JP); MIYAZAKI Tomoyuki, Hitachinaka-shi, Ibaraki 312-8503 (JP); ANDO Kazuhiko, Hitachinaka-shi, Ibaraki 312-8503 (JP)
(74) Representative: Hoffmann Eitle
(86) International application number: PCT/JP2024/003741
(87) International publication number: WO 2024/166872

(57) **Abstract**

This shock absorber generates a damping force by imparting a resistance to a working fluid. The shock absorber includes a cylinder filled with the working fluid, a piston sliding with respect to an inner circumferential surface of the cylinder, a piston rod coupled to the piston and protruding outward from the cylinder, and an elastic resin seal ring slidably supporting an outer circumferential surface of the piston rod. At least one of the outer circumferential surface of the piston rod, the inner circumferential surface of the cylinder, and an outer circumferential surface of the piston has a multi-element amorphous film with a hydrogen content of 15 at% or more.

## Description

### TECHNICAL FIELD

The present invention relates to a shock absorber.

Priority is claimed on Japanese Patent Application No. 2023-019086, filed February 10, 2023, the content of which is incorporated herein by reference.

### BACKGROUND ART

Patent Document 1 discloses a technology related to an amorphous diamond-like carbon film which is utilized as an overlay layer in machine components and the like requiring wear resistance and low friction.

### Citation List

### Patent Document

Patent Document 1: Japanese Patent No. 4473592

### SUMMARY OF INVENTION

### Technical Problem

Patent Document 1 describes that a low frictional coefficient that is inherent to a diamond-like carbon film can be obtained by removing fine projections which have a size of several tens to several hundreds of nanometers and are generated when an overlay layer of a diamond-like carbon film is polished.

Specifically, in a static friction range and a low-speed range in which a sliding direction of sliding components with a working oil therebetween is switched when they start to move or perform reciprocating motion, an oil film becomes thin due to the slow speed so that the fine projections cause physical snagging, which adversely affects the frictional coefficient. In hydraulic shock absorbers for automobiles, motorcycles, and the like, friction caused by the projections significantly affects operability. It is described that if there are no such fine projections, friction with respect to a chromium plating would decrease by approximately 30% to 60%, and that since diamond-like carbon films are inherently hard and have good wear resistance, favorable surface conditions can be maintained for a long period of time.

However, in the technology in the related art, since a sliding friction force of a hydraulic shock absorber is highly dependent on a vibration frequency, it is not possible to achieve sliding characteristics in a stable low-friction state.

According to the present invention, wettability of a working liquid is improved by forming a multi-element amorphous film with a controlled elemental concentration as the outermost layer, and functional groups having a high bonding strength with respect to the working liquid are disposed. Accordingly, frequency dependency of a sliding friction force in a hydraulic shock absorber can be reduced, and a shock absorber capable of achieving stable sliding characteristics with a small frictional coefficient can be provided.

### Solution to Problem

A shock absorber according to an aspect of the present invention is a shock absorber generating a damping force by imparting a resistance to a working fluid. This shock absorber includes a cylinder filled with the working fluid, a piston sliding with respect to an inner circumferential surface of the cylinder, a piston rod coupled to the piston and protruding outward from the cylinder, and an elastic resin seal ring slidably supporting an outer circumferential surface of the piston rod. At least one of the outer circumferential surface of the piston rod, the inner circumferential surface of the cylinder, and an outer circumferential surface of the piston has a multi-element amorphous film with a hydrogen content of 15 at% or more.

### Advantageous Effects of Invention

According to the foregoing shock absorber, frequency dependency of a sliding friction force of a hydraulic shock absorber can be reduced, and low-frictional sliding characteristics can be achieved at the same time. If this shock absorber is used for automobiles or motorcycles, for example, it is possible to provide automobiles or motorcycles with improved ride comfort and steering stability. In addition, since the multi-element amorphous film in the foregoing shock absorber has a high resistivity, an effect of being able to significantly improve corrosion resistance is exhibited.

### BRIEF DESCRIPTION OF DRAWINGS

[FIG. 1] A cross-sectional view showing an overall constitution of a shock absorber according to a first embodiment of the present invention.
[FIG. 2] A front view showing a general shape of a piston rod provided in the same shock absorber.
[FIG. 3] A view showing a structure of a tip portion of the same piston rod and is an enlarged partial cross-sectional view of the part A in FIG. 1.
[FIG. 4] A view showing a structure of an upper portion of the same shock absorber and is an enlarged partial cross-sectional view of the part B in FIG. 1.
[FIG. 5] A partial cross-sectional view showing an example of a plated film and a multi-element amorphous film formed in the same piston rod.
[FIG. 6] A flowchart showing an example of a step of manufacturing the same piston rod.
[FIG. 7] A graph showing an example of results of analysis of a multi-element amorphous film provided in the same piston rod by photoelectron spectroscopy.
[FIG. 8] A graph showing an example of results of analysis of an amorphous carbon film in the related art by photoelectron spectroscopy.
[FIG. 9] A graph showing an example of a Lissajous waveform obtained by a micro-amplitude vibration test.
[FIG. 10] A graph showing frequency dependency of micro-amplitude sliding friction in shock absorbers of an example and comparative examples.
[FIG. 11] A graph showing a relationship of a largest frictional force and a relationship of a thin film hardness with respect to a sum total of atomic concentrations of nitrogen and oxygen in multi-element amorphous films.

### DESCRIPTION OF EMBODIMENT

Hereinafter, a shock absorber (cylinder device) as a first embodiment of the present invention will be described.

The embodiments described below are specific description for better understanding of the gist of the invention and do not limit the present invention unless otherwise specified. In addition, in the drawings used in description of the embodiments described below, the scale will be suitably changed to make each portion easier to see.

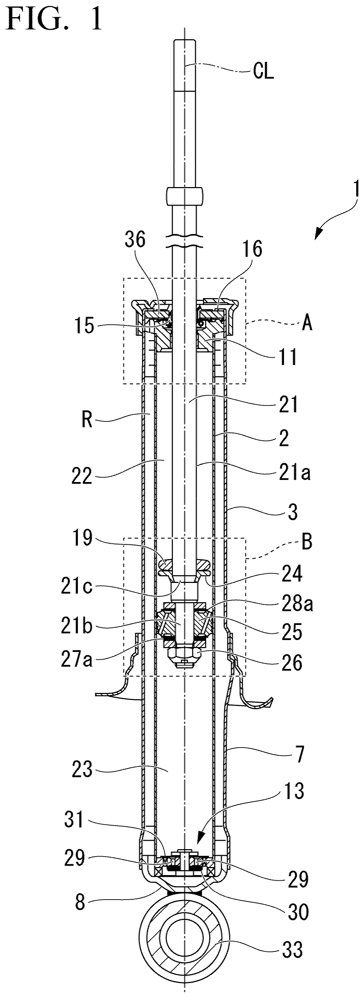

FIG. 1 is a partial cross-sectional view showing an overall structure of a shock absorber 1 of the first embodiment including a cylinder 2, a piston rod 21, and a piston 25.

A multi-element amorphous film (which will be described below) is formed on an inner circumferential surface of the cylinder 2, an outer circumferential surface of the piston rod 21, and an outer circumferential surface of the piston 25. Before the multi-element amorphous film is described, an overall constitution of the shock absorber 1 will be described.

### Shock absorber

The shock absorber 1 shown in FIG. 1 is a shock absorber used in suspension devices for automobiles and railway vehicles. The shock absorber 1 is used specifically in strut-type suspension devices for automobiles. This shock absorber 1 has the cylinder (inner cylinder) 2 which has a cylindrical shape filled with a working fluid, and an outer cylinder 3 which has a larger diameter than the cylinder 2, is provided on an outer circumferential side of the cylinder 2, forms a reservoir chamber R having a working liquid (oil) and a working gas enclosed therein between the outer cylinder 3 and the cylinder 2, and has a bottomed cylindrical shape. This shock absorber 1 is a multicylinder shock absorber in which the cylinder 2 is provided inside the outer cylinder 3. In FIG. 1, CL indicates a centerline of the cylinder 2 and the outer cylinder 3.

The outer cylinder 3 has a cylindrical side wall portion 7, and a bottom portion 8 closing one end side of the side wall portion 7 in an axial direction. The cylinder 2 has a cylindrical shape. The cylinder 2 is engaged with the bottom portion 8 of the outer cylinder 3 via a toric base valve 13 attached to one end portion thereof in the axial direction. The cylinder 2 is engaged with the other end side of the side wall portion 7 in the axial direction via a toric rod guide 11 attached to the other end portion thereof in the axial direction.

The base valve 13 is disposed coaxially with the outer cylinder 3. The rod guide 11 is fitted into the cylinder 2 and the outer cylinder 3, thereby supporting the other end portion of the cylinder 2 coaxially with the outer cylinder 3.

In the rod guide 11, an oil seal 15 is disposed on a side opposite to the bottom portion 8 side. An interlocking portion 16 bending inward is formed on the other end portion side of the side wall portion 7 in the axial direction. The oil seal 15 is supported by the interlocking portion 16.

The piston 25 is slidably fitted into the cylinder 2. This piston 25 divides the inside of the cylinder 2 into a first chamber 22 and a second chamber 23. The first chamber 22 is formed between the piston 25 and the rod guide 11, and the second chamber 23 is formed between the piston 25 and the base valve 13. The second chamber 23 is separated from the reservoir chamber R by the base valve 13 provided on one end side of the cylinder 2.

The metal piston rod 21 is joined to the piston 25 by a nut 26.

The piston rod 21 has a columnar large diameter portion 21a. The piston rod 21 passes through the rod guide 11 and the oil seal 15 and protrudes outward from one end side of the cylinder 2 and the outer cylinder 3. The large diameter portion 21a of the piston rod 21 is slidably inserted through the inward side of the rod guide 11 and the inward side of the oil seal 15. Thus, the oil seal 15 serves as a sliding component with respect to the piston rod 21.

A small diameter portion 21b is formed on the tip side of the piston rod 21. The piston 25 is attached to the piston rod 21 by inserting the piston 25 through this small diameter portion 21b and screwing the nut 26 to a screw portion at the tip of the small diameter portion.

An annular groove 21c is formed at a position close to the small diameter portion 21b in the large diameter portion 21a of the piston rod 21. A ring-shaped internal stopper 24 is mounted in a manner of being engaged with this annular groove 21c. A ring-shaped rebound rubber 19 is disposed on the internal stopper 24.

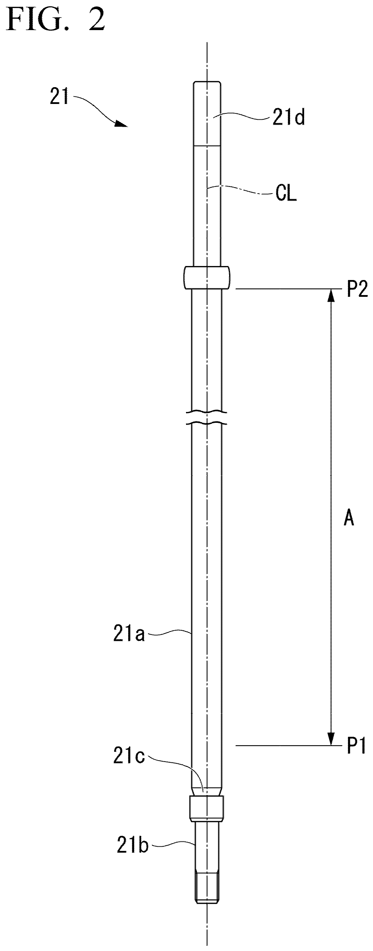

As shown in FIG. 2, in the large diameter portion 21a of the piston rod 21, a part between a position P1 away from the annular groove 21c and a position P2 of a portion connected to a bolt portion 21d serving as an attachment portion with respect to a vehicle body becomes a sliding range A.

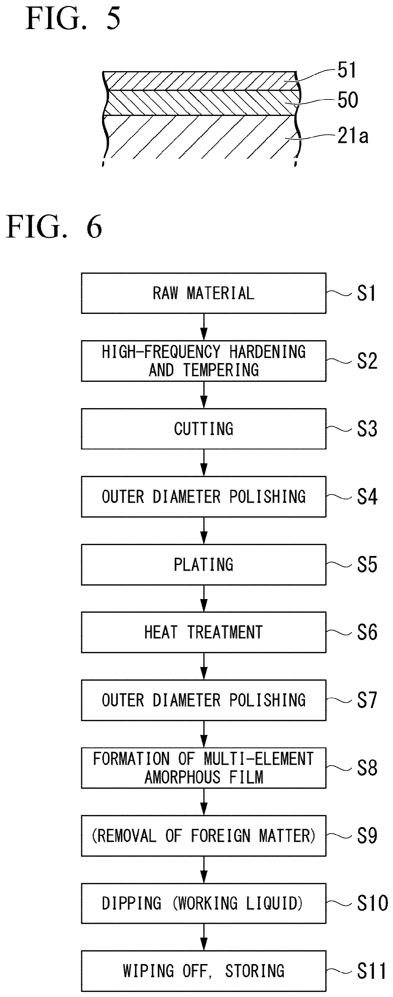

A plated film 50 is formed as a base film mainly composed of chromium on the outer circumferential surface including the sliding range A of the piston rod 21 as shown in FIG. 5, and a multi-element amorphous film 51 (which will be described below) is formed on a surface of the plated film 50. Although it is omitted in FIGS. 1 to 4, a plated film and a multi-element amorphous film are also formed on the inner circumferential surface of the cylinder 2 and the outer circumferential surface of the piston 25 in a similar manner.

The piston rod 21 moves in the axial direction integrally with the piston 25. The oil seal 15 through which the large diameter portion 21a of the piston rod 21 is inserted closes the space between the cylinder 2 and the outer cylinder 3, and the piston rod 21, thereby preventing the working fluid inside the inner cylinder 2 and the working gas and the working fluid inside the reservoir chamber R from leaking to the outside.

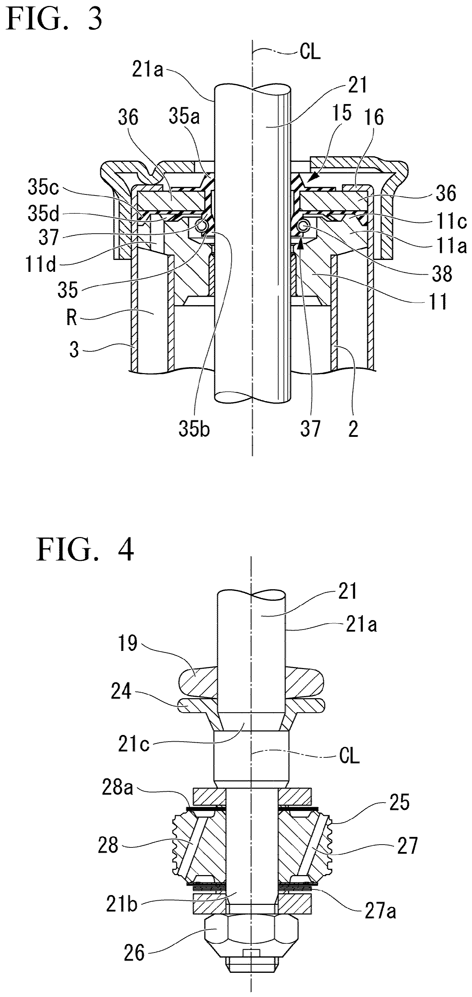

As shown in FIG. 4, passages 27 and 28 penetrating the piston 25 in the axial direction are formed in the piston 25. As shown in FIG. 1, the passages 27 and 28 allow the first chamber 22 and the second chamber 23 to communicate with each other.

A toric disk valve 28a capable of closing the passage 28 by abutting an upper surface of the piston 25 is formed in the piston 25. A toric disk valve 27a capable of closing the passage 27 by abutting a lower surface of the piston 25 is formed in the piston 25.

If the piston rod 21 moves to a contraction side (descending in FIG. 1) where the amount of entry to the inside of the inner cylinder 2 and the inside of the outer cylinder 3 increases, the piston 25 moves in a direction in which the second chamber 23 narrows. If the pressure in the second chamber 23 becomes higher than the pressure in the first chamber 22 by a predetermined value or greater, the disk valve 28a opens the passage 28, and a damping force is generated at this time.

If an upper end side of the piston rod 21 moves to an extension side (ascending in FIG. 1) where the amount of protruding from the inner cylinder 2 and the outer cylinder 3 increases, the piston 25 moves in a direction in which the first chamber 22 narrows. As a result, if the pressure in the first chamber 22 becomes higher than the pressure in the second chamber 23 by a predetermined value or greater, the disk valve 27a opens the passage 27, and a damping force acts at this time.

As shown in FIG. 1, passages 29 and 29 penetrating the base valve 13 in the axial direction are formed in the base valve 13. The passages 29 allow the second chamber 23 and the reservoir chamber R to communicate with each other. A toric disk valve 30 capable of closing the passage 29 on one side by abutting a bottom surface side of the base valve 13 is disposed on the bottom surface side of the base valve 13. A toric disk valve 31 capable of closing the passage 29 on the other side by abutting an upper surface side of the base valve 13 is disposed on the upper surface side of the base valve 13.

The disk valve 30 is a check valve allowing a flow of the working liquid from the second chamber 23 to the reservoir chamber R side through the passage 29 on one side while restricting the flow of the working liquid through the passage 29 in the opposite direction. The disk valve 30 is a valve opening the passage 29 if the piston rod 21 moves to the contraction side and the pressure in the second chamber 23 becomes higher than the pressure in the reservoir chamber R by a predetermined value or greater.

The disk valve 31 is a check valve allowing a flow of the working liquid from the reservoir chamber R to the second chamber 23 side through the passage 29 on the other side while restricting the flow of the working liquid through the passage 29 in the opposite direction. The disk valve 31 is a valve opening the passage 29 if the piston rod 21 moves to the extension side and the pressure in the second chamber 23 becomes lower than the pressure in the reservoir chamber R by a predetermined value or greater.

As shown in FIG. 1, an attachment eye 33 is attached to the outward side of the bottom portion 8. The shock absorber 1 is used by attaching a tip portion of the piston rod 21 on the outward side and the attachment eye 33 between relative movement members which are attachment targets.

For example, if the shock absorber 1 is used for automobiles, it is used by joining an outer end of the piston rod 21 to a vehicle body side of a vehicle and joining the attachment eye 33 to a wheel side of the vehicle.

In the shock absorber 1, the piston rod 21 and the piston 25 integrally slide inside the cylinder 2 and change the volumes of the first chamber 22 and the second chamber 23. At this time, a damping force can be generated due to a flow resistance of a liquid acting on the piston 25 and the base valve 13.

As shown in FIG. 3 the rod guide 11 has substantially a stepped toric shape. A large diameter portion 11a is formed on one side of the rod guide 11 in the axial direction, and the small diameter portion is formed on the other side. The large diameter portion 11a is fitted to the inner circumferential surface of the outer cylinder 3. The small diameter portion is fitted to the inner circumferential surface of the inner cylinder 2.

An annular projecting portion 11c having a toric shape protruding in the axial direction is formed in an end portion of the large diameter portion 11a of the rod guide 11. A communication hole 11d penetrating the rod guide 11 in the axial direction is formed correspondingly to a part of the annular projecting portion 11c. In the communication hole 11d, a side opposite to the annular projecting portion side in the axial direction of the rod guide 11 opens to the reservoir chamber R.

The oil seal 15 has a seal member main body 37 that is an integrally molded product in which a metal annular member 36 is fitted into an elastic resin seal material (elastic resin seal ring) 35 such as synthetic rubber, and a metal annular spring 38. The annular member 36 maintains the shape of the seal material 35 and imparts strength to the seal member main body 37 for fixing it to a target part. The seal member main body 37 is mounted on the end portion side of the outer cylinder 3 by sandwiching the annular member 36 between the interlocking portion 16 and the annular projecting portion 11c.

The seal member 35 has a dust lip portion 35a, an oil lip portion 35b, a seal ring portion 35c, and a check lip portion 35d and exhibits a sealing function by surrounding an area around the piston rod 21.

The shock absorber 1 during traveling of the vehicle has a constitution in which the piston rod 21 or the outer cylinder 3 repeatedly receives an impact force from the outside in the axial direction. Every time an impact force is received, the piston rod 21 moves to the contraction side or the extension side, and a damping force acts at this time. In this manner, the shock absorber 1 exhibits a function as a shock absorber used in strut suspensions of automobiles.

In addition, the plated film 50 and the multi-element amorphous film 51 are provided on the outer circumferential surface of the piston rod 21.

Due to the presence of the plated film 50 and the multi-element amorphous film 51, even if the large diameter portion 21a of the piston rod 21 repeatedly slides with respect to the seal material 35, excellent sliding characteristics can be exhibited and excellent wear resistance can be achieved.

In addition, a plated film and a multi-element amorphous film are also provided on the inner circumferential surface of the cylinder 2 and the outer circumferential surface of the piston 25. Due to the presence of these, the cylinder 2 and the piston 25 also exhibit excellent sliding characteristics and excellent wear resistance.

When the piston rod 21 is provided with the multi-element amorphous film 51, it is preferable that the multi-element amorphous film 51 be provided in at least the sliding range A (a part of the piston rod 21) which is a part of the piston rod 21. Naturally, the multi-element amorphous film 51 may be provided in the piston rod 21 in its entirety.

When a multi-element amorphous film is provided on the inner circumferential surface of the cylinder 2, it is preferable that a multi-element amorphous film be provided in at least the range where the piston 25 slides. Naturally, the multi-element amorphous film 51 may be provided on the entire inner surface of the cylinder 2. When the piston rod 21 slides with respect to the seal material 35, the multi-element amorphous film 51 can be regarded as a sliding member.

When a multi-element amorphous film is provided in the piston 25, it is preferable that a multi-element amorphous film be provided in at least the range where the piston 25 slides with respect to the inner circumferential surface of the cylinder 2. Naturally, the multi-element amorphous film 51 may be provided on the entire outer surface of the piston 25.

Hereinafter, a step of manufacturing a piston rod will be described. Moreover, a method for manufacturing a multi-element amorphous film, and a structure and operational effects thereof will be described in detail.

FIG. 6 is a flowchart showing an example of a step of manufacturing the piston rod 21.

As shown in Step S1 of FIG. 6, a rod-shaped raw material such as a steel rod made of a steel material of a kind required to constitute the piston rod 21 is prepared.

In Step S2, this rod-shaped raw material is subjected to heat treatment such as high-frequency hardening and tempering and is subjected to surface hardening treatment suitable for piston rods.

Next, in Step S3, cutting is performed so as to obtain a general shape shown in FIGS. 1 to 4, and in Step S4, outer diameter grinding is performed.

Next, in Step S5, the piston rod having a general shape shown in FIGS. 1 to 4 is subjected to base plating treatment such as a nickel plating and is subsequently subjected to chromium plating treatment mainly composed of chromium. In the step of performing base plating treatment, different base plating treatment may be performed in place of the nickel plating. The step of performing base plating treatment may be omitted, and the base plating may be omitted.

After plating treatment is performed in Step S5, heat treatment is performed in Step S6. Heat treatment can be performed for approximately several hours at 250 to 400°C. After plating treatment, baking treatment can also be performed for the purpose of removing hydrogen, and therefore this baking treatment and heat treatment may be performed in combination.

Next, in Step S7, the outer diameter of the piston rod is polished and precision finishing processing is performed so that a piston rod having a final surface shape can be obtained.

After outer diameter polishing, in Step S8, a multi-element amorphous film is formed using a vacuum device.

In addition, if it appears that there is any defect such as foreign matter on a surface of the multi-element amorphous film, the foreign matter on the surface is removed in Step S9 using an abrasive or the like.

Next, in Step S10, the piston rod (multi-element amorphous film) is dipped into a working liquid (oil). It is desirable to treat this Step S10 as soon as possible after the multi-element amorphous film has been formed (Step S8) and left in the air. This is because the multi-element amorphous film formed on the outermost surface of the piston rod improves the wettability of the working liquid and many functional groups having a strong bonding strength are disposed therein, so that the amount of adhered atmospheric components increases as time elapses and the number of functional groups bonded to the working liquid decreases.

It is preferable that the film thickness of the multi-element amorphous film be 10 nm to 3,000 nm.

In addition, it is preferable that the film thickness distribution of the multi-element amorphous film be ±2% or smaller.

When the film thickness distribution of the multi-element amorphous film is ±2% or smaller, it becomes a film thickness distribution which can be visually perceived as a single color by humans. For example, regarding the multi-element amorphous film, if the film thickness is gradually increased within a range of 0.20 to 0.30 µm, the color tone changes from red to blue, yellow green, and yellow.

If the color tone of the multi-element amorphous film is a single color, the beauties can be unified, which is advantageous for appearance inspection and the like.

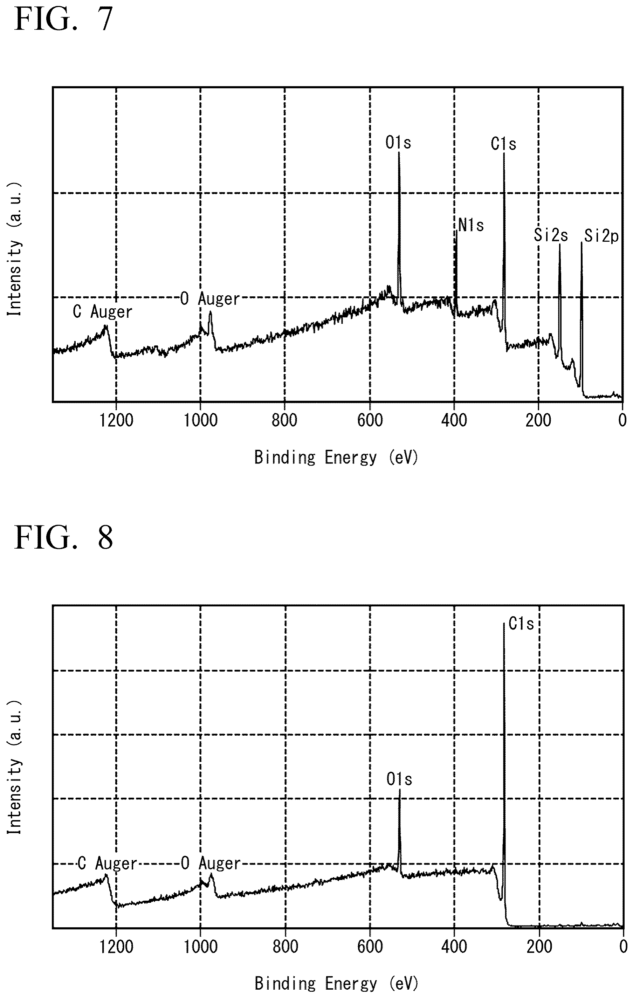

FIG. 7 shows an example of measurement results of a surface of a multi-element amorphous film (amorphous structure film) formed by photoelectron spectroscopy (XPS) in an example which will be described below.

From the results, the presence of oxygen (O), nitrogen (N), carbon (C), and silicon (Si) on the surface of the multi-element amorphous film can be confirmed. However, in regard to the material used when this multi-element amorphous film is formed, it can be confirmed by a hydrogen forward scattering method (HFS) that 15 at% or more of hydrogen is contained at all times (hydrogen content is 15 at% or more). Since the presence of hydrogen cannot be confirmed by the XPS, technical description of this application will be given in terms of atomic concentration excluding hydrogen atoms.

Meanwhile, FIG. 8 shows an XPS profile of an amorphous carbon (DLC: diamond-like carbon) film which is generally used. In the amorphous carbon film, the presence of only oxygen and carbon can be confirmed.

Here, the XPS is an analytical method in which a sample is irradiated with soft X-rays in a high vacuum and the kinetic energy distribution of photoelectrons emitted from a surface of the sample due to an photoelectric effect is measured. The XPS is an analytical method in which energy of electrons (binding energy) that are bound to atoms and present in a solid surface layer by approximately several nanometers can be calculated and identification of atoms and analysis of a chemical state can be performed.

In elastic recoil detection, the hydrogen forward scattering (HFS) method targeted at hydrogen is utilized as means for quantifying the hydrogen concentration in a hydrogenated carbon film. The HFS analysis is known as analytical means capable of measuring the hydrogen concentration contained in any film regardless of the material.

It is possible to presume that a large number of functional groups, such as - CHO, -COOH, -CO-, -COO-, -OH, -O-, -NH₂-, and -NO₂, are present as functional groups on the surface of the multi-element amorphous film formed as described above. It is conceivable that the multi-element amorphous film having a large number of functional groups on its surface have greater surface energy and higher wettability than amorphous carbon films which are generally used. For example, in a general amorphous carbon film, the presence of six kinds of functional groups, such as -CHO, - COOH, -CO-, -COO-, -OH, and -O-, can be expected, but eight functional groups described above are present in the multi-element amorphous film.

Therefore, it is possible to presume that the multi-element amorphous film have a large bonding strength (bonded ratio) with respect to the working fluid (oil).

In the shock absorber 1 having a structure described above, when the piston rod 21 relatively slides with respect to the elastic resin seal material 35 with the working fluid (oil) therebetween, it is conceivable that a frictional force generated therebetween significantly change depending on the surface structure of the multi-element amorphous film.

Thus, it is considered important that the outer circumferential surface of the piston rod 21 be reliably coated with the working fluid to prevent a boundary lubrication state.

In this regard, if the piston rod 21 has the multi-element amorphous film described above on its outermost surface, the multi-element amorphous film is a film containing many elements, such as C, H, O, N, and Si, and having various functional groups described above on its surface. Therefore, the outermost surface has a high ability to retain the working liquid due to the functional groups described above, which contributes to reduction of a frictional force. In addition, since the multi-element amorphous film contains Si, it has high adhesion, and corrosion resistance of the piston rod is also significantly improved.

### [Examples]

Hereinafter, the present invention will be further described based on examples, but the present invention is not limited to the examples described below.

### (Example 1)

A piston rod, which was provided with a hard chromium plating (film thickness of approximately 20 µm) that had been subjected to outer diameter polishing (Step S7) in accordance with the flow shown in FIG. 6, was produced using a steel rod (diameter: 22 mm, length: 400 mm) based on JIS S45C as a raw material. Here, the hard chromium plating which would serve as a base layer of a multi-element amorphous film had a Vickers hardness of 850 HV or greater in a Vickers hardness test method defined in ISO 6507.

Next, a multi-element amorphous film (amorphous structure film) was formed (Step S8) using a vacuum device.

The vacuum device used in the present example had a mechanism capable of holding and transporting six piston rods in a vacuum (<2 Pa) inside a transportation chamber and a mechanism capable of uniformly heating them up to the maximum of 300°C in a vacuum. A rotary pump and a mechanical booster pump were connected in series as a vacuum pump, and evacuation was performed.

In addition, a reaction chamber for forming a multi-element amorphous film was connected to the transportation chamber described above while remaining in a vacuum. The reaction chamber had a mechanism for introducing gas and had a structure in which a high-frequency power source for generating capacitively coupled plasma was connected to the piston rod via a matching device and a multi-element amorphous film could be formed on the outer circumferential surface of the piston rod. Argon (Ar), gasified hexamethyldisilazane (NH[Si(CH₃)₃]₂), toluene (C₇H₈), nitrogen (N₂), and oxygen (O₂) were used as the introduced gas.

A specific process for forming a multi-element amorphous film (Step S8) will be described below.

The piston rod was heated in a vacuum (<2 Pa) at 200°C for ten minutes in a transportation heating chamber and was transported to the reaction chamber while the vacuum was maintained. Since this vacuum heating cleaned the surface and also promoted dehydrogenation in the piston rod, the potential for hydrogen brittle fracture could be reduced.

Next, 50 sccm of argon gas was introduced into the reaction chamber, and the gas pressure was adjusted to 5 Pa. Further, etching treatment (pre-treatment) in which high-frequency power of 400 W was applied and held for 600 s was performed. At this time, the self-bias generated on the surface of the piston rod was approximately -600 V.

Next, 5 sccm of vaporized hexamethyldisilazane was introduced, and the pressure in the reaction chamber was adjusted to 0.5 Pa. Thereafter, high-frequency power of 200 W was applied. The self-bias generated on the surface of the piston rod at this time was approximately -1,000 V. In addition, since the gas introduced into the reaction chamber was a reactive gas, the gas was decomposed simultaneously with generation of plasma, and the gas pressure became approximately 1.2 Pa.

Since the film formation speed was 2.0 nm/s, a multi-element amorphous film having a film thickness of approximately 1.2 µm was obtained after a treatment time of 600 s.

Next, in order to remove surface foreign matter (Step S9) having a size of several tens to several hundreds of nanometers on the surface of the piston rod taken out from the vacuum device, the surface was polished with a wiping cloth to remove foreign matter from the surface. Immediately after this, the piston rod was dipped (Step S10) in a working oil.

The surface energy of the multi-element amorphous film was measured in a stage before dipping (Step S10), and it was 52 mN/m. The surface energy was measured by the method described below.

### [Surface energy measurement method]

In contrast to the surface tension of a liquid, the surface tension of a solid is referred to as surface energy. Further, the value thereof can be obtained from "contact angle θ" with respect to two or more kinds of liquids. In the present example, pure water and diiodomethane were used. In addition, the surface energy was measured after Step S8 ended and the multi-element amorphous film was left in the air for one hour.

Next, this piston rod was assembled into the shock absorber as shown in FIGS. 1 to 4, and measurement of the largest frictional force at each frequency was evaluated using a micro-amplitude vibrator.

A seal material was constituted using nitrile-based rubber, and a hydrocarbon-based mineral oil containing 73% of paraffin-based hydrocarbon and 27% of naphthene-based hydrocarbon was used as a lubricating oil. This mineral oil was a fluorine-free lubricating oil (hydrocarbon-based lubricating oil).

A test using the micro-amplitude vibrator was performed as follows. A frictional force was measured by changing the frequency within 0.16 to 40 Hz and setting a measurement region within ±1 mm of the intermediate length of the piston rod.

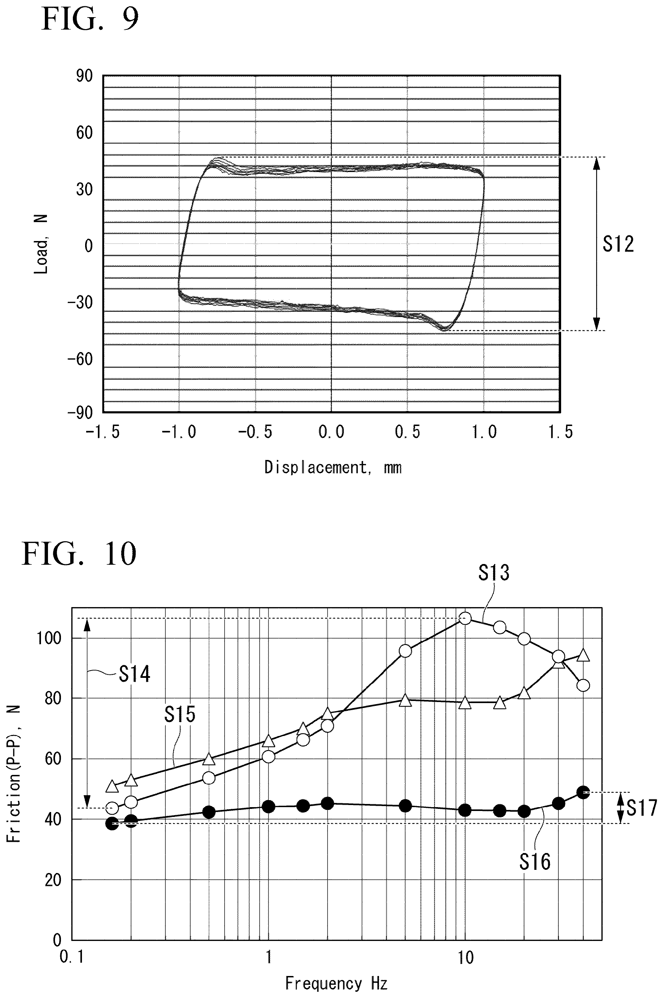

The largest frictional force difference (P-P) was set as a difference between the largest frictional force on the extension side and the largest frictional force on the contraction side (peak to peak) of the suspension at each frequency. As an example, this largest frictional force difference corresponded to the largest height (S12) of the frictional force having a Lissajous waveform obtained at each frequency shown in FIG. 9, which could be obtained from a general amorphous carbon film (DLC film) in the related art.

A multi-element amorphous film was formed as described above, a Lissajous figure similar to that shown in FIG. 9 was obtained for the dipped piston rod by a similar method, and the largest height of the frictional force of the Lissajous waveform was measured.

Regarding the details of frequency dependency test conditions, a preliminary vibration (amplitude: 30 mm, frequency: 0.53 Hz, vibration time: 600 s) was applied, and then vibration was applied. A similar test was performed three times at intervals of 60 s, and the average value was obtained.

In addition, for comparison, similar test and measurement were performed for a piston rod provided with a hard chromium plating that had been subjected to outer diameter polishing (Step S7) in accordance with the flow shown in FIG. 6, and a piston rod provided with an amorphous carbon film (1.2 µm) in the related art having the surface structure in FIG. 8.

FIG. 10 shows measurement results of the largest frictional force with respect to the frequency for shock absorbers provided with three kinds of piston rods described above. In the piston rod provided with a hard chromium plating in the related art (S13), the largest frictional force was highly dependent on the frequency, and the displacement amplitude had a large value, that is, approximately 60 N (S14), within a measurement frequency range (0.16 to 40 Hz). In addition, frequency dependency thereof was not linear.

The piston rod provided with an amorphous carbon film coating in the related art (S15) had smaller frequency dependency than the piston rod provided with a hard chromium plating, but the largest frictional force contrarily indicated a higher value at a frequency lower than 3 Hz.

Meanwhile, in the piston rod provided with the multi-element amorphous film of the present example (S16), it could be confirmed that the frequency dependency of the largest frictional force was small within the measurement frequency range and the displacement amplitude was approximately 10 N approximately (S17). In addition, the largest frictional force also indicated the lowest value throughout the entire frequency range (0.16 to 4,040 Hz).

Since roughness parameters for the surfaces of the piston rods constituting these three kinds of suspensions had similar values, it was conceivable that the differences in frequency dependency shown in FIG. 10 be based on the differences in interaction between the surface of the piston rods of the respective samples and the working liquid (oil).

Hence, the XPS intensity on the surface of the multi-element amorphous film formed in the present example was measured by photoelectron spectroscopy (XPS). FIG. 7 shows the results. From FIG. 7, the atomic concentrations on the surface were 13 at% of oxygen, 12 at% of nitrogen, 48 at% of carbon, and 27 at% of silicon.

Therefore, it could be confirmed that functional groups of -NH₂, -NO₂, -CHO, - COOH, -CO-, -COO-, -OH, and -O- were present on the surface of the amorphous structure film of the present example, the surface energy was high, the wettability with the working liquid was favorable, and there were many functional groups having a high bonding strength with respect to the working liquid.

Meanwhile, FIG. 8 shows the XPS intensity obtained from a surface of an amorphous carbon film-coated product in the related art.

From FIG. 8, the atomic concentrations on the surface were 12 at% of oxygen and 88 at% of carbon, and therefore it was found that the number of functional groups was small and the number of functional groups having a high bonding strength was smaller than that of the multi-element amorphous film of the present example.

From the sliding test results and the surface observation results of these, the difference in sliding characteristics between them was considered as follows using models divided into a fixing layer in which the working liquid was bonded to the surface of the piston rod, and a free layer in which the working liquid was not bonded to the surface of the piston rod.

Hard chromium plated product (S13): The surface of the piston rod was made of a metal and the wettability with the working liquid was high. However, due to its low bonding strength, the fixing layer was unstable, the frequency dependency of the frictional force became high, and the frictional force also became unstable.

Amorphous carbon film-coated product in the related art (S15): Since there are few kinds of functional groups on the surface of the piston rod, the wettability with the working liquid was low, but the bonding strength was high to a certain degree. Therefore, compared to the hard chromium plated product, the fixing layer was stably present, and the frequency dependency of the frictional force was improved. However, since the fixing layer was not sufficient, the frictional force became high.

Multi-element amorphous film of example (S16): Since the surface of the piston rod had many highly reactive functional groups, the wettability with the working liquid was high, and the surface had a high bonding strength. Therefore, the fixing layer was strong and generated in large quantities. The frequency dependency of the frictional force was low, and the frictional force was also low.

### (Example 2)

In order to confirm the effects of the functional groups on the surface of the multi-element amorphous film, NH[Si(CH₃)₃]₂, C₇H₈, N₂, and O₂ used when forming a multi-element amorphous film were adjusted, the total atomic concentration of oxygen and nitrogen was changed, and the largest frictional force and the thin film hardness corresponding to them were evaluated.

The largest frictional force was measured at a frequency of 1 Hz with a measurement region within ±1 mm of the intermediate length of the piston rod. The largest frictional force difference (P-P) was set as a difference between the largest frictional force on the extension side and the largest frictional force on the contraction side (peak to peak) of the suspension at each frequency (corresponding to the largest height (S12) of the frictional force having a Lissajous waveform obtained at each frequency shown in FIG. 9).

Regarding the details of frequency dependency test conditions, a preliminary vibration (amplitude: 30 mm, frequency: 0.53 Hz, vibration time: 600 s) was applied, and then vibration was applied. A similar test was performed three times at intervals of 60 s, and the average value was obtained.

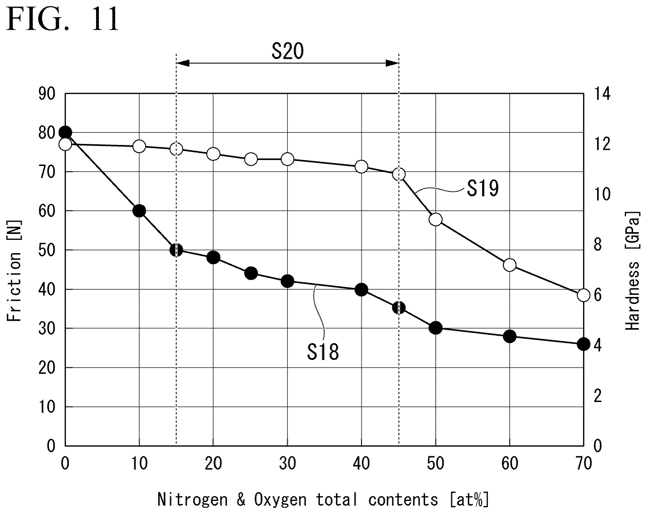

In FIG. 11, the horizontal axis indicates the total atomic concentration of nitrogen and oxygen obtained by the XPS, the left vertical axis indicates the largest frictional force (S18), and the right horizontal axis indicates the hardness of the multi-element amorphous film (S19).

From the results shown in FIG. 11, it could be confirmed that the film hardness suddenly dropped when the total atomic concentration of nitrogen and oxygen exceeded 45 at%. It was conceivable that this was because the number of single bonds decreased as the number of double bonds constituted by oxygen and nitrogen increased, resulting in decrease in mechanical strength. In addition, on the contrary, when the total atomic concentration was lower than 15 at%, the largest frictional force increased. It was conceivable that this was because the number of functional groups for making the working liquid into fixing layers was insufficient.

Therefore, when the total atomic concentration of nitrogen and oxygen (sum total of atomic concentrations) was within a range of 15 at% to 45 at% (S20), the largest frictional force of 50 [N] or smaller, which the inventors considered necessary, could be obtained, and a thin film hardness of 10 [GPa] or higher could be obtained.

In addition, when the total atomic concentration of nitrogen and oxygen was within a range of 15 at% to 45 at% (S20), the surface energy was measured and found to be 50 [mN/m] or higher. The surface energy of the general hard chromium plated product in the related art was approximately 40 [mN/m].

### (Example 3)

Since the multi-element amorphous film of the example is an amorphous structure film containing hydrogen, the resistivity is 10⁴ Ωm or higher, and it has insulating properties of 10⁶ Ωm or higher depending on the film formation conditions. This high resistivity, that is, the insulating properties prevent oxidation (removal of electrons) of the steel rod caused by cracking, defects, or the like of the hard chromium plated film (film thickness of 20 µm) serving as a base film and significantly improve the corrosion resistance of the piston rod.

Specifically, a salt spray combined cyclic test (CCT), which was an automobile material corrosion test according to JASO M609-91, was performed, and the piston rod with a hard chromium plating showed spot rust after five cycles. Incidentally, the piston rod of the present example provided with the multi-element amorphous film described above showed no rust at all even after 30 cycles.

Next, the corrosion resistance of the multi-element amorphous film was evaluated by the salt spray combined cyclic test.

### [Salt spray combined cyclic test]

Salt spray combined cyclic test stipulated in automobile material corrosion test according to JASO M609-91 (1 cycle: [salt spray conditions 35°C, 2 hours, 5% NaCl]→[dry 60°C, 6 hours, 25±5% RH]→[wet 50°C, 2 hours, >95% RH])

As a result of the salt spray combined cyclic test described above, it could be confirmed that no rust occurred at all after 30 cycles on the multi-element amorphous film even if the film thickness was 0.1 µm. In order to secure corrosion resistance, considering that it was necessary for cracking and a defect in at least the hard chromium plated film which was the base film to be coated, it was presumed that the insulating properties of the multi-element amorphous film significantly contributed thereto.

### (Example 4)

In the foregoing Example 1, a piston rod, on which a hard chromium plating having a thickness of approximately 20 µm was formed, was used as a base film for the multi-element amorphous film (film thickness of 1.2 µm). However, the film stress and the film thickness of the base film were major factors determining the adhesion of the multi-element amorphous film. This was because the multi-element amorphous film of the present invention had compressive stress (negative value), and therefore the base film was important as a stress relaxation layer for curbing film peeling.

Stress of the base film has a positive value compared to the compressive stress (negative value) of the multi-element amorphous film, and a relaxation effect thereof increases as the film thickness becomes larger. In addition, the presence of microcracking or the like in the base film itself increases the relaxation effect therein.

In the present example, in order to confirm the largest film thickness of the multi-element amorphous film when a hard chromium plated film (film thickness of 20 µm) was used as the base film, the film thickness was increased, and its adhesion was confirmed.

As a result, with the film thickness of 3.4 µm, peeling occurred when it was left in the air immediately after the step of forming the multi-element amorphous film (step S8). It was conceivable that the cause of this be that the stress relaxation effect of the base film was insufficient with respect to the internal compressive stress of the multi-element amorphous film, resulting in decrease in adhesion.

However, since no peeling occurred with the film thickness of the multi-element amorphous film up to 3.3 µm, it was found that it was sufficient for at least the base film of the multi-element amorphous film of the present invention to have the film thickness approximately six times or more than that of the multi-element amorphous film.

Meanwhile, when the film thickness of the multi-element amorphous film small, no adhesion problem occurs. However, the smallest film thickness was examined for the purpose of forming functional groups on the outermost layer.

As a result, similarly to that of a thick film, the film thickness at which a stable atomic concentration could be obtained in the XPS measurement was approximately 0.01 µm.

Therefore, it was understood that a desirable film thickness of the multi-element amorphous film was within a range of 0.01 µm to 3.30 µm.

### (Example 5)

The working liquid of the hydraulic shock absorber used in Example 1 was a generally used hydrocarbon-based mineral oil substantially containing no fluorocarbon. In the present example, a plant oil (plant-based working fluid) was also examined.

The expression "substantially containing no fluorocarbon" used herein means that even if a very small amount of fluorocarbon is actually contained, it will not have any practical.

The main component of the mineral oil was a compound of carbon and hydrogen, and the main component of the plant oil was a compound of carbon, hydrogen, and oxygen. Meanwhile, the multi-element amorphous film of the present invention was constituted using carbon, nitrogen, oxygen, hydrogen, and silicon and was compatible with the plant oil without any problem.

Hence, in the present example, a micro-amplitude sliding test was performed as a hydraulic shock absorber using a plant oil as the working liquid in a manner similar to that in the test of Example 1.

As a result, it could be confirmed that there was no frequency dependency similarly to that in Example 1. In addition, regarding the frictional force, favorable results which were lower than those in Example 1 by approximately 30% could be obtained.

### INDUSTRIAL APPLICABILITY

According to the present invention, frequency dependency of a sliding friction force of a hydraulic shock absorber can be reduced, and low-frictional sliding characteristics can be achieved at the same time. If this shock absorber is used for automobiles or motorcycles, for example, it is possible to provide automobiles or motorcycles with improved ride comfort and steering stability. In addition, since a multi-element amorphous film in a shock absorber of the present invention has a high resistivity, an effect of being able to significantly improve corrosion resistance is exhibited

### REFERENCE SIGNS LIST

1 Shock absorber (shock absorber)
2 Cylinder (inner cylinder)
3 Outer cylinder
15 Oil seal
21 Piston rod (sliding contact member)
25 Piston
35 Seal material (elastic resin seal ring)
50 Plated film (base film)
51 Multi-element amorphous film
A Sliding range

## Claims

1. A shock absorber generating a damping force by imparting a resistance to a working fluid, the shock absorber comprising:
a cylinder filled with the working fluid;
a piston sliding with respect to an inner circumferential surface of the cylinder;
a piston rod coupled to the piston and protruding outward from the cylinder; and
an elastic resin seal ring slidably supporting an outer circumferential surface of the piston rod,
wherein at least one of the outer circumferential surface of the piston rod, the inner circumferential surface of the cylinder, and an outer circumferential surface of the piston has a multi-element amorphous film with a hydrogen content of 15 at% or more.

2. The shock absorber according to claim 1,
wherein a sum total of atomic concentrations of N and O contained on an outermost surface of the multi-element amorphous film is 15 to 45 at%.

3. The shock absorber according to claim 1,
wherein a film thickness of the multi-element amorphous film is 0.01 µm to 3.30 µm.

4. The shock absorber according to claim 1,
wherein the multi-element amorphous film is a sliding member used in the presence of a hydrocarbon-based lubricating oil substantially not containing fluorine.

5. The shock absorber according to claim 1, further comprising:
a base film,
wherein the base film has a Vickers hardness of 850 HV or greater based on a Vickers hardness test method defined in ISO 6507.

6. The shock absorber according to claim 5,
wherein the base film has a film thickness corresponding to six times or more than a film thickness of the multi-element amorphous film.

7. The shock absorber according to claim 1,
wherein the working fluid contains a plant-based working fluid.

8. The shock absorber according to claim 1,
wherein at least one of the outer circumferential surface of the piston rod, the inner circumferential surface of the cylinder, and the outer circumferential surface of the piston partially has the multi-element amorphous film.

9. The shock absorber according to claim 1,
wherein the multi-element amorphous film is formed at least on the outer circumferential surface of the piston rod, and the multi-element amorphous film on the outer circumference of the piston rod has insulating properties.

10. The shock absorber according to claim 1,
wherein a film thickness distribution of the multi-element amorphous film on the outer circumference of the piston rod is within ±2%.
